# DEMANDE DE BREVET EUROPEEN

(11) **EP 3 910 781 A1**
(43) Date de publication de la demande: **17.11.2021**
(21) Numéro de dépôt: 21172991.8
(22) Date de dépôt: 10.05.2021
(51) Int. Cl.: H02M 7/00

(54) **MODULE ÉLECTRIQUE AVEC SURMOULAGE ET DISPOSITIFS COMPRENANT UN TEL MODULE ÉLECTRIQUE**

(30) Priorité: 11.05.2020 FR 2004613
(71) Demandeur: VALEO EQUIPEMENTS ELECTRIQUES MOTEUR, 94046 Créteil Cedex (FR)
(72) Inventeur: VERCAMBRE, Virginie, 94046 CRETEIL CEDEX (FR); FALGUIER, Manuel, 94046 CRETEIL CEDEX (FR); GONCALVES-DA-COSTA, Ricardo, 94046 CRETEIL CEDEX (FR); BERTRAND, Mathieu, 94046 CRETEIL CEDEX (FR)
(74) Mandataire: Valeo Powertrain Systems

(57) **Abrégé**

L'invention concerne un module électrique comportant une première (304₁) et une deuxième (304₂) pièces de connexion électrique présentant chacune une plaque principale (306₁, 306₂), un premier composant électrique (112₁) monté sur une face supérieure de la plaque principale (306₂) de la deuxième pièce de connexion électrique (304₂), un premier élément de liaison électrique (326₁) connectant électriquement la face supérieure de la plaque principale (306₁) de la première pièce de connexion électrique (304₁) à la face supérieure de la plaque principale (306₂) de la deuxième pièce pièces de connexion électrique (304₂) ; et un surmoulage isolant électrique (402), par exemple en résine, recouvrant ledit premier composant électrique (112₁) et au moins une partie de la face supérieure de la plaque principale (306₁, 306₂) de la première (304₁) et de la deuxième (304₂) pièces de connexion électrique, ledit module électrique (110) étant caractérisé en ce que la face supérieure du surmoulage isolant électrique (402) présente une cavité (C) et en ce qu'au moins une partie du premier élément de liaison électrique (326₁) est située dans ladite cavité (C).

## Description

La présente invention concerne un module électrique avec surmoulage, un système électrique et un convertisseur de tension comprenant un tel module électrique.

Il est connu de l'art antérieur des modules électriques comprenant :
- une première et une deuxième pièces de connexion électrique, de préférence en métal, présentant chacune une plaque principale, les plaques principales s'étendant selon un même plan principal de manière à être sensiblement coplanaires ;
- un premier composant électrique monté sur une face supérieure de la plaque principale de la deuxième pièce de connexion électrique ; et
- un surmoulage isolant électrique, par exemple en résine, recouvrant ledit premier composant électrique et au moins une partie des faces supérieures de la première et de la deuxième plaque principale.

Or, en cas de surchauffe du composant électrique, par exemple en cas de court-circuit si le composant électrique est un interrupteur commandable, la chaleur se diffuse dans l'isolant électrique de sorte que celui-ci risque de prendre feu, mettant en péril les éléments environnants.

L'invention a pour but de pallier au moins en partie le problème précité.

Il est donc proposé, selon un premier aspect de l'invention, un module électrique comprenant :
- une première et une deuxième pièces de connexion électrique, de préférence en métal, présentant chacune une plaque principale, les plaques principales s'étendant selon un même plan principal de manière à être sensiblement coplanaires ;
- un premier composant électrique monté sur une face supérieure de la plaque principale de la deuxième pièce de connexion électrique ;
- un premier élément de liaison électrique connectant électriquement la face supérieure de la plaque principale de la première pièce de connexion électrique à la face supérieure de la plaque principale de la deuxième pièce pièces de connexion électrique ; et
- un surmoulage isolant électrique, par exemple en résine, recouvrant ledit premier composant électrique et au moins une partie de la face supérieure de la plaque principale de la première et de la deuxième pièces de connexion électrique ;
   ledit module électrique étant caractérisé en ce que la face supérieure du surmoulage isolant électrique présente une cavité, et en ce qu'une partie du premier élément de liaison électrique est située dans la cavité.

Ce module électrique est caractérisé en ce que la face supérieure du surmoulage isolant électrique présente une cavité dans laquelle est situé au moins partiellement le premier élément de liaison électrique.

Grâce à cette caractéristique technique, au moins une partie du premier élément de liaison électrique n'est pas soumis à la force de maintien du surmoulage isolant électrique ce qui permet une rupture plus facile de ce premier élément de liaison électrique lorsqu'il s'échauffe.

Ainsi, le premier élément de liaison électrique dans le module électrique selon l'invention se rompt à une température plus faible que celui dans le module électrique selon l'art antérieur. Grâce à cette rupture à une température plus faible, réchauffement du premier composant électrique est limité.

En d'autres termes, grâce à la cavité située dans laquelle est située le premier élément de liaison électrique, la température du surmoulage isolant électrique du module électrique selon l'invention reste plus faible en cas de défaut de fonctionnement du premier composant électrique que dans le module électrique selon l'art antérieure de sorte que le module électrique selon l'invention risque moins de prendre feu.

Un module électrique selon l'invention peut en outre comporter une ou plusieurs des caractéristiques optionnelles suivantes, prises isolément ou bien selon n'importe quelle combinaison techniquement possible.

Selon une première caractéristique, la première pièce de connexion électrique est différente de la deuxième pièce de connexion électrique.

Selon une autre caractéristique, la première pièce de connexion électrique est destinée à être connectée à une borne positive d'une source de tension continue ou à une phase d'une machine électrique tournante.

Selon une autre caractéristique, le module électrique est un module de puissance.

Selon une autre caractéristique, le module électrique est un module électrique destiné à être implanté ou utilisé dans un véhicule automobile.

Selon une autre caractéristique, le module électrique est un module électrique destiné à réaliser un bras de commutation.

Selon une autre caractéristique, le module électrique est un module électrique destiné à réaliser un bras de commutation d'un convertisseur de tension.

Selon une autre caractéristique, la première pièce de connexion électrique comprend au moins un connecteur électrique se projetant depuis sa plaque principale.

Selon une autre caractéristique, le connecteur électrique de la première pièce de connexion électrique se projette depuis la plaque principale de la première pièce de connexion électrique dans le plan principal.

Selon une autre caractéristique, le connecteur électrique et la plaque principale de la première pièce de connexion électrique le portant sont réalisés en une seul pièce par continuité de matière.

Selon une autre caractéristique, le premier composant électrique est connecté électriquement à la face supérieure de la plaque principale de la deuxième pièce de connexion électrique.

Selon une autre caractéristique, le surmoulage isolant électrique est intégral en une seule pièce.

Selon une autre caractéristique, le surmoulage isolant électrique recouvre le reste du premier élément de liaison électrique.

Selon une autre caractéristique, la totalité du premier élément de liaison électrique est située dans la cavité.

Selon une autre caractéristique, la cavité est remplie de gel ou d'une résine présentant une dureté moindre que celle du surmoulage isolant électrique.

Selon une autre caractéristique, le premier élément de liaison électrique comprend un ou plusieurs rubans et/ou un ou plusieurs fils et/ou un ou plusieurs fusibles, chacun desdits rubans et/ou chacun desdits fils et/ou chacun desdits fusibles connectant électriquement la face supérieure de la plaque principale de la première pièce de connexion électrique à la face supérieure de la plaque principale de la deuxième pièce pièces de connexion électrique.

Selon une autre caractéristique, le premier élément de liaison électrique comprend en outre un plot, une extrémité de chaque ruban en métal et/ou de chaque fil et/ou de chaque fusible est soudée sur ledit plot par un premier procédé de soudage, par exemple par ultrason, ledit plot étant soudé sur la face supérieure de la plaque principale de la première ou de la deuxième pièce de connexion électrique par un deuxième procédé de soudage, par exemple par brasage, la soudure obtenue par le deuxième procédé de soudage présentant une tenue en température inférieure à celle obtenue par le premier procédé de soudage.

Selon une autre caractéristique, le plot et l'extrémité de chaque ruban en métal et/ou de chaque fil et/ou de chaque fusible soudée sur le plot sont situés dans la cavité.

Selon une autre caractéristique, la première pièce de connexion électrique est destinée à être connectée à une borne positive d'une source de tension continue et le module électrique comprend en outre :
- une troisième et une quatrième pièce de connexion électrique présentant une plaque principale s'étendant selon le plan principal ;
- un deuxième élément de liaison électrique connectant électriquement ledit premier composant électrique à la face supérieure de la plaque principale de la troisième pièces de connexion électrique ;
- un deuxième composant électrique monté sur la face supérieure de la plaque principale de la troisième pièce de connexion électrique ;
- un troisième élément de liaison électrique connectant électriquement ledit deuxième composant électrique à la face supérieure de la plaque principale de la quatrième pièces de connexion électrique ; et
   dans lequel le surmoulage isolant électrique recouvre le deuxième composant électrique et au moins une partie de la face supérieure de la plaque principale de la troisième et de la quatrième pièce de connexion électrique.

Selon une autre caractéristique, la troisième pièce de connexion électrique comprend au moins un connecteur électrique se projetant depuis sa plaque principale.

Selon une autre caractéristique, le connecteur électrique de la troisième pièce de connexion électrique se projette depuis la plaque principale de la troisième pièce de connexion électrique dans le plan principal.

Selon une autre caractéristique, le connecteur électrique et la plaque principale de la troisième pièce de connexion électrique le portant sont réalisés en une seul pièce par continuité de matière.

Selon une autre caractéristique, la quatrième pièce de connexion électrique comprend au moins un connecteur électrique se projetant depuis sa plaque principale.

Selon une autre caractéristique, le connecteur électrique de la quatrième pièce de connexion électrique se projette depuis la plaque principale de la quatrième pièce de connexion électrique dans le plan principal.

Selon une autre caractéristique, le connecteur électrique et la plaque principale de la quatrième pièce de connexion électrique le portant sont réalisés en une seul pièce par continuité de matière.

Selon une autre caractéristique, le surmoulage isolant électrique recouvre complètement le deuxième élément de liaison électrique et le troisième élément de liaison électrique.

Selon une autre caractéristique, le surmoulage isolant électrique recouvre complètement le deuxième composant électrique et/ou le premier composant électrique.

Selon une autre caractéristique, le deuxième composant électrique est connecté électriquement à la face supérieure de la plaque principale de la troisième pièce de connexion électrique.

Selon une autre caractéristique, le premier composant électrique et le deuxième composant électrique sont des transistors appelés respectivement premier et deuxième transistor, le premier transistor et le deuxième transistor sont connectés électriquement l'un à l'autre par l'intermédiaire de la plaque principale de la troisième pièce de connexion électrique, la plaque principale de la troisième pièce de connexion électrique étant destinée à être connecté à une phase d'une machine électrique, le premier transistor est en outre connecté électriquement à la plaque principale de la deuxième pièces de connexion électrique, la plaque principale de la première pièce de connexion électrique est destinée à être connectée à une borne positive de ladite source de tension continue, et la plaque principale de la quatrième pièces de connexion électrique est en outre destiné à être connecté à une borne négative de ladite source de tension continue.

Selon une autre caractéristique, chaque transistor, d'une part, présente une face inférieure plaquée contre l'une des deux faces supérieures auxquelles ce transistor est connecté électriquement et, d'autre part, est connecté électriquement, par exemple par un ou plusieurs rubans ou fils, à l'autre des deux faces supérieures.

Selon une autre caractéristique, le premier composant électrique et/ou le deuxième composant électrique est un transistor de type FET (de l'anglais « Field-Effect Transistor ») ou de type IGBT (de l'anglais « Insulated-Gate Bipolar Transistor »).

Selon une autre caractéristique, le transistor de type FET est un MOSFET en silicium (Si-MOSFET) ou en carbure de silicium (SiC-MOSFET) ou est un transistor FET en nitrure de gallium (GaN-FET).

Selon une autre caractéristique, le premier composant électrique et/ou le deuxième composant électrique est un transistor HEMT (de l'anglais « high-electron-mobility transistor ») par exemple en nitrure de gallium.

Selon une autre caractéristique, le premier transistor à la forme d'une plaque, par exemple sensiblement rectangulaire, présentant une face supérieure et une face inférieure.

Selon une autre caractéristique, le deuxième transistor à la forme d'une plaque, par exemple sensiblement rectangulaire, présentant une face supérieure et une face inférieure.

Selon une autre caractéristique, le premier transistor présente une face inférieure plaquée contre la face supérieure de la plaque principale de la deuxième pièce de connexion électrique à laquelle le premier transistor est connecté.

Selon une autre caractéristique, le deuxième transistor présente une face inférieure plaquée contre la face supérieure de la plaque principale de la troisième pièce de connexion électrique à laquelle le deuxième transistor est connecté.

Selon une autre caractéristique, le surmoulage laisse apparent au moins une partie de la face inférieure de la plaque principale d'au moins une des pièces de connexion électrique, cette partie laissée apparente étant conçue pour être plaquée contre un dissipateur thermique.

Selon une autre caractéristique, le surmoulage présente un plot de résine se projetant vers le bas
Selon une autre caractéristique, les plaques principales sont séparées les unes des autres selon le plan principal par au moins un interstice et le surmoulage remplit chaque interstice et présente, dans chaque interstice, une face inférieure affleurant des faces inférieures des plaques principales.

Selon une autre caractéristique, le plot de résine se projette depuis la face inférieure du surmoulage présent dans l'interstice.

Selon une autre caractéristique, les pièces de connexion électrique sont obtenues par découpage d'une seule plaque métallique.

Selon un deuxième aspect de l'invention, il est également proposé un système électrique comprenant un dissipateur thermique et un module électrique selon le premier aspect de l'invention et dans lequel le dissipateur thermique est en contact thermique avec la face inférieure laissée apparente par le surmoulage.

Selon un troisième aspect de l'invention, il est également proposé un convertisseur de tension comprenant un module électrique selon le premier aspect de l'invention ou bien un système électrique selon le deuxième aspect de l'invention.

Ce convertisseur de tension est destiné à être connecté entre une source d'alimentation électrique délivrant une tension continue et une machine électrique tournante pour effectuer une conversion entre la tension continue de la source d'alimentation électrique et au moins une tension de phase de la machine électrique tournante.

Selon un quatrième aspect de l'invention, il est également proposé un bras de commutation comprenant un module électrique selon le premier aspect de l'invention ou bien un système électrique selon le deuxième aspect de l'invention.

L'invention sera mieux comprise à l'aide de la description qui va suivre, donnée uniquement à titre d'exemple et faite en se référant aux dessins annexés dans lesquels :
[Fig. 1] la figure 1 représente schématiquement un système électrique comportant un convertisseur de tension mettant en oeuvre l'invention dans un premier mode de réalisation de l'invention,
[Fig. 2] la figure 2 est une vue éclatée en trois dimensions du convertisseur de tension de la figure 1 dans un premier mode de réalisation de l'invention,
[Fig.3] la figure 3 est une vue en trois dimensions de dessus d'un module de puissance du convertisseur de tension de la figure 2, sans surmoulage dans le premier mode de réalisation de l'invention,
[Fig.4] la figure 4 est une vue similaire à celle de la figure 3, avec surmoulage,
[Fig.5] la figure 5 est une vue en trois dimensions de dessous du module de puissance des figures 3 et 4, avec surmoulage,
[Fig.6] la figure 6 est une vue en trois dimensions de dessous d'un module de puissance dans un deuxième mode de réalisation de l'invention,

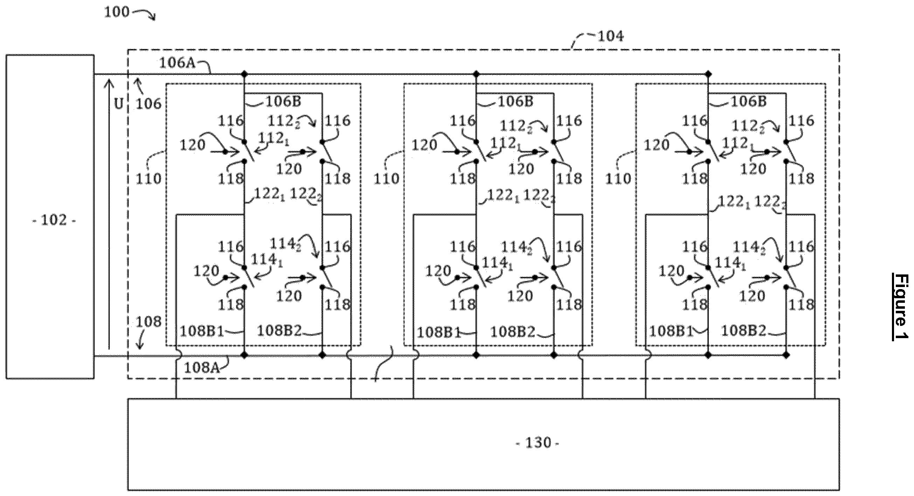

En référence à la figure 1, un système électrique 100 mettant en oeuvre l'invention dans un premier mode de réalisation de l'invention va à présent être décrit.

Le système électrique 100 est par exemple destiné à être implanté dans un véhicule automobile.

Le système électrique 100 comporte tout d'abord une source d'alimentation électrique 102 conçue pour délivrer une tension continue U, par exemple comprise entre 10 V et 100 V, par exemple 48 V ou bien 12 V.

La source d'alimentation électrique 102 est donc une source de tension continue. Cette source d'alimentation électrique comporte par exemple une batterie.

Le système électrique 100 comporte en outre une machine électrique 130 comportant plusieurs phases (non représentées) destinées à présenter des tensions de phase respectives.

Le système électrique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte tout d'abord une barre omnibus positive 106 et une barre omnibus négative 108 destinées à être connectées à la source d'alimentation électrique 102 pour recevoir la tension continue U, la barre omnibus positive 106 recevant un potentiel électrique haut et la barre omnibus négative 108 recevant un potentiel électrique bas.

Le convertisseur de tension 104 comporte en outre au moins un module électrique 110. Ce module électrique 110 est un module de puissance. Le module de puissance 110 comporte une ou plusieurs barres omnibus de phase destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase 122₁, 122₂ connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase 122₁ des modules de puissance 110 sont respectivement connectées aux trois phases du premier système triphasé, tandis que les deuxièmes barres omnibus de phase 122₂ des modules de puissance 110 sont respectivement connectées aux trois phases du deuxième système triphasé.

Chaque module de puissance 110 comporte, pour chaque barre omnibus de phase 122₁, un premier composant électrique, (ici un interrupteur de côté haut 112₁) connecté entre la barre omnibus positive 106 et la barre omnibus de phase 122₁ et un deuxième composant électrique (ici un interrupteur de côté bas 114₁), connecté entre la barre omnibus de phase 122₁ et la barre omnibus négative 108. Ainsi, les interrupteurs 112₁, 114₁ sont agencés de manière à former un bras de commutation, dans lequel la barre omnibus de phase 122₁ forme un point milieu.

Chaque module de puissance 110 comporte également, pour chaque barre omnibus de phase 122₂, un troisième composant électrique (ici un interrupteur de côté haut 112₂) connecté entre la barre omnibus positive 106 et la barre omnibus de phase 122₂ et un quatrième composant électrique (ici un interrupteur de côté bas 114₂), connecté entre la barre omnibus de phase 122₂ et la barre omnibus négative 108. Ainsi, les interrupteurs 112₂, 114₂ sont agencés de manière à former un bras de commutation, dans lequel la barre omnibus de phase 122₂ forme un point milieu.

Chaque interrupteur 112₁, 114₁, 112₂, 114₂ comporte des première et deuxième bornes principales 116, 118 et une borne de commande 120 destinée à sélectivement ouvrir et fermer l'interrupteur 112₁, 114₁, 112₂, 114₂ entre ses deux bornes principales 116, 118 en fonction d'un signal de commande qui lui est appliqué. Les interrupteurs 112₁, 114₁, 112₂, 114₂ sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118. Alternativement, les interrupteurs 112₁, 114₁, 112₂, 114₂ pourraient être des transistors bipolaires à grille isolée (de l'anglais « Insulated Gâte Bipolar Transistor » ou IGBT).

Dans l'exemple décrit, les interrupteurs 112₁, 114₁, 112₂, 114₂ ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. Les interrupteurs 112₁, 114₁, 112₂, 114₂ sont destinés à être traversés, entre leurs bornes principales 116, 118, par un courant supérieure à 1 A.

Il sera apprécié que la barre omnibus positive 106, la barre omnibus négative 108 et les barres omnibus de phase 122₁, 122₂ sont des conducteurs électriques rigides conçus pour supporter les courants électriques d'au moins 1 A destinés à traverser les interrupteurs 112₁, 114₁, 112₂, 114₂. Elles présentent de préférence une épaisseur d'au moins 1 mm.

Par ailleurs, dans l'exemple décrit, la barre omnibus positive 106 comporte tout d'abord une barre omnibus commune positive 106A reliant les modules de puissance 110 et, dans chaque module de puissance 110, une barre omnibus locale positive 106B connectée à la barre omnibus commune positive 106A. De manière similaire, la barre omnibus négative 108 comporte une barre omnibus commune négative 108A reliant les modules de puissance 110 et, dans chaque module de puissance 110, une barre omnibus locale négative 108B1, 108B2 pour chaque interrupteur de côté bas 114₁, 114₂, les barres omnibus locales négatives 108B1, 108B2 étant connectées à la barre omnibus commune négative 108A. Les connexions sont représentées sur la figure 1 par des losanges.

En outre, dans l'exemple décrit, la barre omnibus commune positive 106A et la barre omnibus commune négative 108A sont chacune formée d'une seule pièce conductrice.

En outre, dans l'exemple décrit, la machine électrique 130 a à la fois une fonction d'alternateur et de moteur électrique. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique 130 fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

Dans la suite de la description, la structure et la disposition des éléments du convertisseur de tension 104 vont être décrits plus en détails, en référence à une direction verticale H-B, « H » représentant le haut et « B » représentant le bas. Cette direction verticale H-B étant notée sur les figures par la référence V.

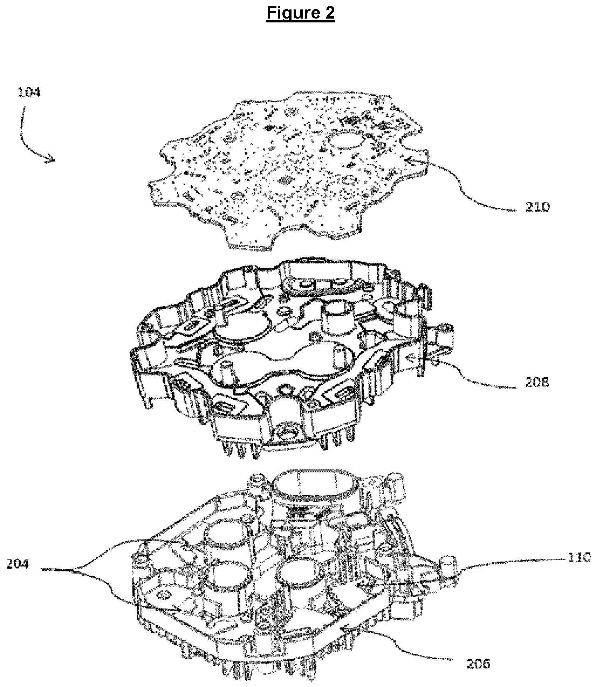

En référence à la **figure 2**, le convertisseur de tension 104 comprend un dissipateur thermique 206, également appelé dissipateur de chaleur, présentant des surfaces d'échange thermique 204 sur lesquelles sont respectivement montés les modules de puissance 110 (un seul module de puissance 110 est représenté sur la figure 2). L'échange thermique entre la surface d'échange thermique 204 du dissipateur thermique 206 et le module de puissance 110 est réalisé par exemple grâce à un contact, direct ou par l'intermédiaire d'une pate conductrice thermiquement, entre la surface d'échange thermique 204 du dissipateur thermique 206 et le module de puissance 110.

Le convertisseur de tension 104 comprend également un boitier support 208 sur lequel est fixé un module électronique secondaire comme un module de contrôle 210. Dans l'exemple de la figure 1, le module de contrôle 210 est une carte de contrôle. En outre et de façon optionnelle, le boitier support 208 est monté sur le dissipateur thermique 206.

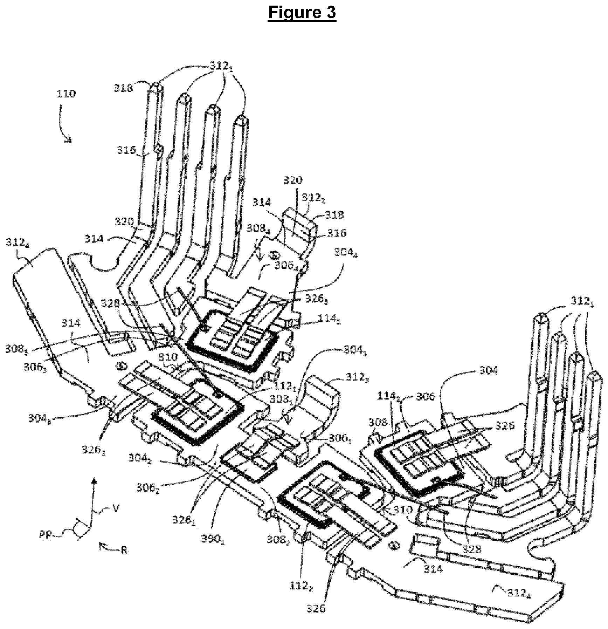

En référence à la **figure 3****,** le module de puissance 110 comporte plusieurs pièces de connexion électrique 304, 304₁, 304₂, 304₃, 304₄ de préférence en métal.

Chaque pièce de connexion électrique 304, 304₁, 304₂, 304₃, 304₄ présente une plaque principale 306, 306₁, 306₂, 306₃, 306₄ s'étendant selon un plan principal PP horizontal, le même pour toutes les plaques principales 306, 306₁, 306₂, 306₃, 306₄ de manière que les plaques principales 306, 306₁, 306₂, 306₃, 306₄ soient sensiblement coplanaires. En particulier, dans l'exemple décrit, les plaques principales 306, 306₁, 306₂, 306₃, 306₄ présentent des faces supérieures 308, 308₁, 308₂, 308₃, 308₄ horizontales respectives s'étendant au même niveau. Par soucis de clarté, les faces supérieures 308, 308₁, 308₂, 308₃, 308₄ ne sont indiquées sur la figure 3 que pour certaines des plaques principales 306, 306₁, 306₂, 306₃, 306₄.

En particulier, le module de puissance 110 comporte une première pièce de connexion électrique 304₁ ayant une plaque principale 306₁ présentant une face supérieure 308₁, une deuxième pièce de connexion électrique 304₂ ayant une plaque principale 306₂ présentant une face supérieure 308₂, une troisième pièce de connexion électrique 304₃ ayant une plaque principale 306₃ présentant une face supérieure 308₃ et une quatrième pièce de connexion électrique 304₄ ayant une plaque principale 306₄ présentant une face supérieure 308₄.

Par ailleurs, les plaques principales 306, 306₁, 306₂, 306₃, 306₄ sont séparées les unes des autres selon le plan principal PP par au moins un interstice 310. Dans l'exemple décrit, chaque interstice 310 présente une largeur inférieure ou égale à un cinq millimètres. Cela signifie que les deux plaques principales délimitant l'interstice 310 sont distantes d'au plus cinq millimètres le long de cet interstice 310.

En outre, un premier élément de liaison électrique connecte électriquement la face supérieure 308₁ de la plaque principale 306₁ de la première pièce de connexion électrique 304₁ à la face supérieure 308₂ de la plaque principale 306₂ de la deuxième pièce pièces de connexion électrique 304₂.

Le premier élément de liaison électrique comprend deux rubans 326₁ et un premier plot 390₁, une première extrémité de chaque ruban en métal 326₁ est soudée sur le plot premier 390₁ par un premier procédé de soudage, par exemple par un procédé de soudure par ultrason ou par un procédé de soudure par friction. Le premier plot 390₁ est par ailleurs soudé sur la face supérieure de la plaque principale 306₂ de la deuxième pièce de connexion électrique 304₂ par un deuxième procédé de soudage, par exemple par brasage. Ainsi, la soudure obtenue par le deuxième procédé de soudage présente une tenue en température inférieure à celle obtenue par le premier procédé de soudage. Une deuxième extrémité de chaque ruban en métal 326₁ est par ailleurs soudée directement sur la face supérieure 308₁ de la plaque principale 306₁ de la première pièce de connexion électrique 304₁ par le premier ou par le deuxième procédé de soudage.

En variante, le premier élément de liaison électrique comprend également un deuxième plot soudé sur la face supérieure de la plaque principale 306₁ de la première pièce de connexion électrique 304₁ par le deuxième procédé de soudage, et la deuxième extrémité de chaque ruban en métal est soudée sur le deuxième plot par le premier ou par le deuxième procédé de soudage.

Dans une autre variante, le premier élément de liaison électrique comprend seulement le deuxième plot et ne comprend pas le premier plot 390₁. Le deuxième plot est soudé sur la face supérieure de la plaque principale 306₁ de la première pièce de connexion électrique 304₁ par le deuxième procédé de soudage, la deuxième extrémité de chaque ruban en métal est soudée sur le deuxième plot par le premier ou par le deuxième procédé de soudage et la première extrémité de chaque ruban en métal 326₁ est soudée directement sur la face supérieure 308₂ de la plaque principale 306₂ de la deuxième pièce de connexion électrique 304₂ par le premier ou par le deuxième procédé de soudage.

Dans une autre variante, le premier élément de liaison électrique comprend seulement les deux rubans 326₁. Une première extrémité de chaque ruban en métal est soudée directement sur la face supérieure de la plaque principale 306₁ de la première pièce de connexion électrique 304₁ par un procédé de soudage, par exemple par un procédé de soudure par ultrason ou par un procédé de soudure par friction et une deuxième extrémité de chaque ruban en métal est soudée directement sur la face supérieure de la plaque principale 306₂ de la deuxième pièce de connexion électrique 304₂ par le même procédé de soudage.

De manière générale, au moins une des pièces de connexion électrique 304, 304₁, 304₃, 304₄ présente en outre au moins un connecteur électrique se projetant depuis sa plaque principale 306, 306₁, 306₃, 306₄. Chaque connecteur électrique est par exemple soit sous la forme d'une broche 312₁, soit sous la forme d'une languette pliée 312₂, 312₃, soit encore sous la forme d'une languette droite 312₄.

Dans l'exemple décrit ici, les languettes droites 312₄ forment avec leurs plaques principales 306₃, 306 les barres omnibus de phase 122₁, 122₂. La barre omnibus locale positive 106B est formée par l'association de la plaque principale 306₂, du premier élément de liaison électrique et de la languette pliée 312₃ associée à sa plaque principale 306₁. Les languettes pliées 312₂ forment avec leurs plaques principales 306₄, 306 les barres omnibus locales négatives 108B1, 108B2.

Chaque connecteur électrique 312₁, 312₂, 312₃ présente une extrémité fixe 314 fixée à la plaque principale 306, 306₁, 306₂, 306₃, 306₄, une portion principale 316 s'étendant verticalement dans l'exemple décrit et se terminant par une extrémité libre 318 et un coude 320 reliant l'extrémité fixe 314 à la portion principale 316. Par soucis de clarté, ces différents éléments des connecteurs électriques 312₁, 312₂, 312₃ ne sont indiqués sur la figure 3 que pour deux connecteurs électriques 312₁, 312₂, l'un en forme de broche, l'autre en forme de languette.

Dans le cas d'une languette droite, le connecteur électrique 312₄ se projette dans le plan principal PP sur une grande longueur afin de permettre sa connexion, par exemple au moins un centimètre. En outre, le connecteur électrique 312₄ présente une extrémité fixe 314 fixée à la plaque principale 306, cette extrémité fixe 314 ayant une grande largeur pour permettre le passage de courant, par exemple d'au moins un centimètre.

Les pièces de connexion électrique 304 sont obtenues dans l'exemple décrit par découpage d'une seule plaque métallique.

Dans l'exemple décrit ici, la plaque métallique est en cuivre. En variante, la plaque métallique pourrait être en aluminium ou encore en or.

Par ailleurs, comme expliqué précédemment, le module de puissance 110 comporte les transistors 112₁, 112₂, 114₁, 114₂ chacun connecté électriquement entre deux faces supérieures 308, 308₂, 308₃, 308₄ de respectivement deux des plaques principales 306, 306₂, 306₃, 306₄ par exemple pour faire passer et interrompre sur commande un courant de puissance, pouvant par exemple être supérieure à un ampère entre ces deux plaques principales 306, 306₂, 306₃, 306₄. Chaque transistor 112₁, 112₂, 114₁, 114₂ présente tout d'abord une face inférieure plaquée contre l'une des deux faces supérieures 308, 308₂, 308₃ auxquelles ce transistor est connecté électriquement. Chaque transistor 112₁, 112₂, 114₁, 114₂ présente en outre une face supérieure dont une partie est connecté électriquement à l'autre des deux faces supérieures. Dans l'exemple décrit, la face supérieure du transistor 112₁, 112₂, 114₁, 114₂ comporte en outre une partie de commande du transistor 112₁, 112₂, 114₁, 114₂, connectée électriquement à une face supérieure d'une troisième plaque principale 306, par exemple par un fil 328 dans l'exemple décrit.

En d'autres termes, le transistor 112₁ est monté sur la face supérieure 308₂ de la plaque principale 306₂ de la deuxième pièce de connexion électrique 304₂ et un deuxième élément de liaison électrique connecte électriquement le transistor 112₁ à la face supérieure 308₃ de la plaque principale 306₃ de la troisième pièce de connexion électrique 304₃.

Le deuxième élément de liaison électrique comprend deux rubans 326₂, une première extrémité de chaque ruban en métal 326₂ est soudée sur la face supérieure du transistor 112₁ par un procédé de soudage, par exemple par soudure par ultrason ou par soudure par friction, et une deuxième extrémité de chaque ruban en métal 326₂ est soudée sur la face supérieure 308₃ de la plaque principale 306₃ de la troisième pièce de connexion électrique 304₃ par le même procédé de soudage.

De même, le transistor 114₁ est monté sur la face supérieure 308₃ de la plaque principale 306₃ de la troisième pièce de connexion électrique 304₃ et un troisième élément de liaison électrique connecte électriquement le transistor 114₁ à la face supérieure 308₄ de la plaque principale 306₄ de la quatrième pièce de connexion électrique 304₄.

Le troisième élément de liaison électrique comprend deux rubans 326₃, une première extrémité de chaque ruban en métal 326₃ est soudée sur la face supérieure du transistor 114₁ par un procédé de soudage, par exemple par soudure par ultrason ou par soudure par friction, et une deuxième extrémité de chaque ruban en métal 326₃ est soudée sur la face supérieure 306₈ de la plaque principale 306₄ de la quatrième pièce de connexion électrique 304₄ par le même procédé de soudage.

De façon similaire, les transistors 112₂ et 114₂ ont leur face supérieure connecté électriquement à une faces supérieures d'une plaque principale 306 au moyen de deux rubans 326.

Dans l'exemple décrit, les rubans 326, 326₁, 326₂, 326₃ sont en aluminium et présente par exemple une section de 2mmx0.3mm. Dans une variante de réalisation, les rubans 326, 326₁, 326₂, 326₃ sont en or.

Dans l'exemple décrit, le plots 390₁ a une forme de plaque rectangulaire de dimension 9.5mm x 7.5mm et présente par exemple une section de 4.64 x 2.94mm pour une épaisseur de 0.15mm. Le plot 390₁ est par exemple formé d'un assemblage d'une couche d'invar entre deux couches de cuivre, ledit assemblage étant réalisé par exemple par un procédé de colaminage. En variante, la couche d'invar peut être remplacé par une couche de molybdène. Dans une autre variante, le plot 390₁ peut être en matériau composite, par exemple en molybdène-cuivre.

Dans l'exemple décrit, le fil 328 est en aluminium et présente un diamètre de 0.2mm Dans une variante de réalisation, le fil 328 est en or.

Dans l'exemple décrit, les connecteurs électriques 312₁ en forme de broche servent à la connexion du module de puissance 110 au module de contrôle 210, afin de faire des mesures de grandeurs électriques et de commander les transistors 112₁, 112₂, 114₁, 114₂.

En outre, toujours dans l'exemple décrit, les connecteurs électriques 312₂ sont connectés à la barre omnibus commune négative 108A et le connecteur électrique 312₃ est connecté à la barre omnibus commune positive 106A.

En outre, toujours dans l'exemple décrit, les deux connecteurs électriques 312₄ en forme de languette droite forment respectivement les deux barres omnibus de phase 122₁, 122₂ du module de puissance 110.

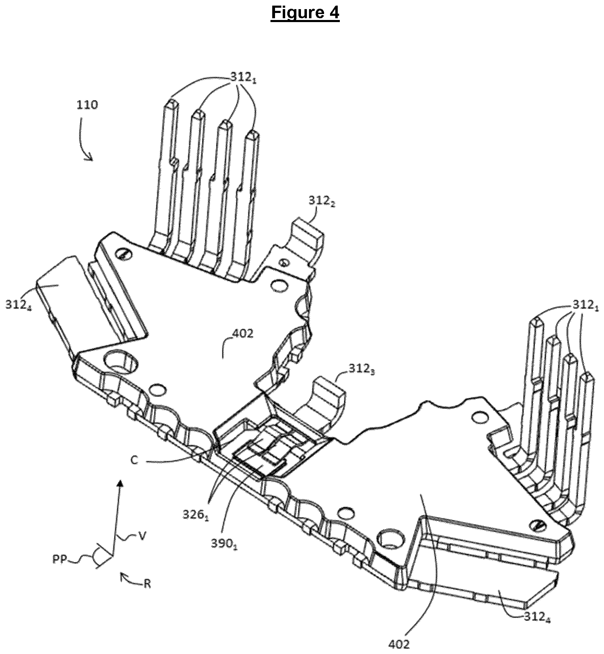

En référence à la **figure 4****,** le surmoulage du module de puissance 110 est représenté et porte la référence 402. Le surmoulage 402 est un isolant électrique et recouvre totalement chaque transistor 112₁, 112₂, 114₁, 114₂ et au moins une partie des faces supérieures 308₁, 308₂, 308₃, 308₄, 308 des plaques principales 306₁, 306₂, 306₃, 306₄, 306.

Dans l'exemple décrit ici, le surmoulage 402 recouvre également totalement chaque fil 328.

En outre, la face supérieure du surmoulage isolant électrique 402 présente une cavité C dans laquelle la totalité du premier élément de liaison électrique est située.

Dans une variante de réalisation, seule une partie du premier élément de liaison électrique est située dans la cavité C et le surmoulage isolant électrique 402 recouvre le reste du premier élément de liaison électrique. Par exemple, les extrémités des deux rubans 326₁ soudées à la face supérieure 308₁ de la plaque principale 306₁ de la première pièce de connexion électrique 304₁ sont recouvert par le surmoulage isolant électrique 402 et le reste du premier élément de liaison électrique est situé dans la cavité C.

De cette façon, le surmoulage isolant électrique n'exerce aucune force de maintien sur le premier élément de liaison électrique ce qui permet une rupture facile des rubans ou de la soudure du ou des plots sur les faces supérieures des pièces de connexion électrique lorsque ce premier élément de liaison électrique s'échauffe.

Le surmoulage 402 est par exemple en résine, par exemple encore en époxy. De préférence, le surmoulage 402 est intégral en une seule pièce.

Dans le mode de réalisation décrit ici, la cavité C est dépourvue de matière. En variante, la cavité C est remplie d'un gel, par exemple diélectrique et/ou en silicone. Le gel peut également avoir une viscosité se situant entre 230 et 600 mPa-s, de préférence entre 400 et 500 mPa-s, par exemple de 465 mPa-s et/ou une dureté comprise entre 65 et 180g, de préférence entre 110 et 160g, par exemple de 123g ou de 154g.

Dans une autre variante, la cavité est remplie d'une résine différente de la résine formant le surmoulage isolant électrique 402. En particulier, la résine remplissant la cavité C possède une dureté moindre que celle formant le surmoulage isolant électrique 402. Par exemple, le surmoulage isolant électrique est formé d'une résine époxy, ayant par exemple une dureté entre 70 et 90 shore et la cavité est remplie d'une résine élastomère, ayant par exemple une dureté entre 20 et 40 shore. La résine remplissant la cavité C peut également appartenir à la classe de feu UL 94 V-0, telle que définie par la compagnie de certification Underwriters Laboratories.

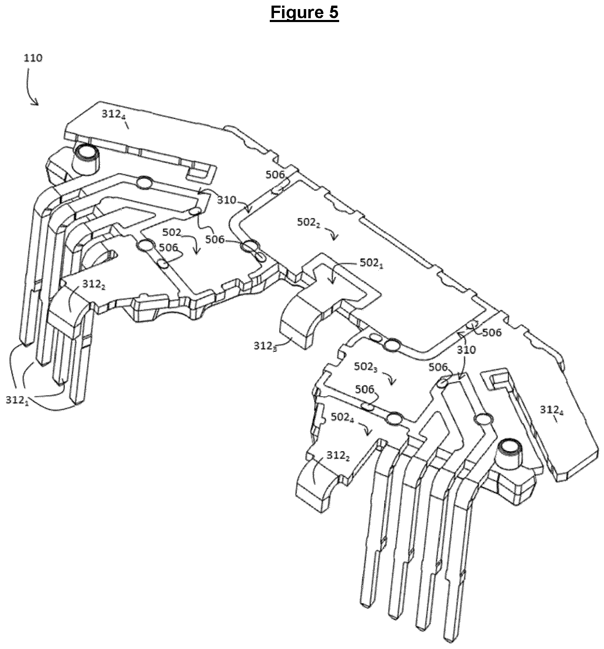

Comme cela est visible sur la **figure 5****,** le surmoulage 402 laisse apparent la face inférieure 502₂ de la plaque principale 306₂ de la deuxième pièce de connexion électrique 304₂. Cette partie laissée apparente est conçue pour être plaquée contre le dissipateur thermique 206. Ainsi, le dissipateur thermique 206 est en contact thermique avec la face inférieure 502₂ laissée apparente par le surmoulage 402. Ce contact thermique peut être un contact direct ou bien via un élément de liaison électrique isolant et thermiquement conducteur.

De même le surmoulage 402 laisse apparent les faces inférieures 502, 502₁, 502₃, 502₄ des plaque principale 306, 306₁, 306₃, 306₄ de chacune des autres pièces de connexion électrique 304, 304₁, 304₃, 304₄. Ces parties laissées apparentes sont conçues pour être plaquée contre le dissipateur thermique 206. Ainsi, le dissipateur thermique 206 est en contact thermique avec les faces inférieures 502, 502₁, 502₃, 502₄ laissées apparentes par le surmoulage 402. Ce contact thermique peut être un contact direct ou bien via un élément de liaison électrique isolant et thermiquement conducteur.

Par ailleurs, il sera apprécié que l'extrémité fixe 314 de chaque connecteur électrique 312₁, 312₂, 312₃, 312₄ présente une face inférieure entièrement découverte de surmoulage 402. En outre, le surmoulage 402 remplit chaque interstice 310 et présente, dans chaque interstice 310, une face inférieure affleurant les faces inférieures 502, 502₁, 502₂, 502₃, 502₄ des plaques principales 206, 206₁, 206₂, 206₃, 206₄.

Le surmoulage 402 présente au moins un plot de résine 506 se projetant vers le bas et conçu pour venir au contact direct du dissipateur thermique 206 afin de définir un écartement prédéfini entre les faces inférieures 502, 502₁, 502₂, 502₃, 502₄ des plaques principales 306, 306₁, 306₂, 306₃, 306₄ et le dissipateur thermique 206, et ainsi l'épaisseur de l'élément conducteur thermique remplissant cet écartement. Dans l'exemple décrit, chaque plot de résine 506 se projette depuis la face inférieure du surmoulage présent dans l'un des interstices 310 entre les plaques principales 306, 306₁, 306₂, 306₃, 306₄.

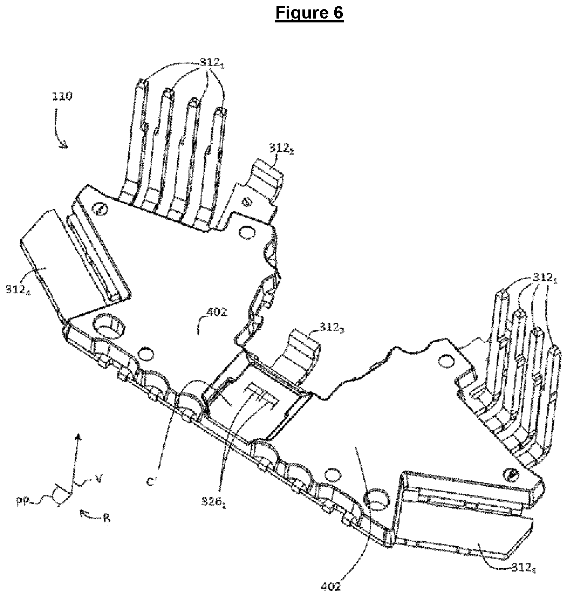

En référence à la **figure 6**, un deuxième mode de réalisation de l'invention va maintenant être présenté. Les éléments identiques, ou analogues à ceux du premier mode de réalisation portent la même référence numérique dans la description du deuxième mode de réalisation.

Dans ce deuxième mode de réalisation de l'invention, la face supérieure du surmoulage isolant électrique 402 présente une cavité C' dans laquelle seule une partie du premier élément de liaison électrique est située, le surmoulage isolant électrique 402 recouvrant le reste du premier élément de liaison électrique.

Dans ce mode de réalisation, le surmoulage isolant électrique 402 recouvre partiellement les rubans 326₁ et seule la partie la plus élevée, par rapport à la direction haut-bas, des rubans 326₁ n'est pas recouverte par le surmoulage isolant électrique 402. En d'autres termes, seule la partie la plus élevée, par rapport à la direction haut-bas, des rubans 326₁ est située dans la cavité C'.

De préférence dans ce mode de réalisation, le premier élément de liaison électrique comprend seulement les deux rubans 326₁. Une première extrémité de chaque ruban en métal est soudée directement sur la face supérieure de la plaque principale 306₁ de la première pièce de connexion électrique 304₁ par un procédé de soudage, par exemple par un procédé de soudure par ultrason ou par un procédé de soudure par friction et une deuxième extrémité de chaque ruban en métal est soudée directement sur la face supérieure de la plaque principale 306₂ de la deuxième pièce de connexion électrique 304₂ par le même procédé de soudage.

En variante, le premier élément de liaison électrique peut également comprendre le premier plot 390₁ et/ou le deuxième plot.

De cette façon, le surmoulage isolant électrique n'exerce aucune force de maintien sur la partie la plus élevée des rubans 326₁ ce qui permet une rupture facile de la partie la plus élevée de ces rubans lorsque ces rubans s'échauffent.

La cavité C' est dépourvue de matières. En variante, cette cavité C' peut être remplie d'un gel ou d'une résine différente de la résine formant le surmoulage isolant électrique 402. Le gel ou la résine remplissant la cavité C' sont par exemple identique au gel ou à la résine remplissant la cavité C du premier mode de réalisation de l'invention.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Par exemple, l'invention n'est pas limitée à un module de puissance tel que précédemment décrit mais s'applique à tous les types de module électrique comprenant deux pièces de connexion électrique reliées électriquement par un premier élément de liaison électrique et un premier composant électrique monté sur la face supérieure d'une des deux pièces de connexion électrique, ledit premier composant électrique étant recouvert par un surmoulage isolant électrique pour éviter que ce premier composant électrique surchauffe au point de mettre le feu au surmoulage isolant électrique.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en oeuvre de l'enseignement qui vient de lui être divulgué.

## Revendications

1. Module électrique (110) comprenant :
- une première (304₁) et une deuxième (304₂) pièces de connexion électrique, de préférence en métal, présentant chacune une plaque principale (306₁, 306₂), les plaques principales (306₁, 306₂) s'étendant selon un même plan principal (PP) de manière à être sensiblement coplanaires ;
- un premier composant électrique (112₁) monté sur une face supérieure de la plaque principale (306₂) de la deuxième pièce de connexion électrique (304₂) ;
- un premier élément de liaison électrique (326₁) connectant électriquement la face supérieure de la plaque principale (306₁) de la première pièce de connexion électrique (304₁) à la face supérieure de la plaque principale (306₂) de la deuxième pièce pièces de connexion électrique (304₂) ; et
- un surmoulage isolant électrique (402), par exemple en résine, recouvrant ledit premier composant électrique (112₁) et au moins une partie de la face supérieure de la plaque principale (306₁, 306₂) de la première (304₁) et de la deuxième (304₂) pièces de connexion électrique;
ledit module électrique (110) étant **caractérisé en ce que** la face supérieure du surmoulage isolant électrique (402) présente une cavité (C) et **en ce qu'**au moins une partie du premier élément de liaison électrique (326₁) est située dans ladite cavité (C).

2. Module électrique (110) selon la revendication précédente dans lequel le surmoulage isolant électrique (402) recouvre le reste du premier élément de liaison électrique (326₁).

3. Module électrique (110) selon la revendication 1 dans lequel la totalité du premier élément de liaison électrique (326₁) est située dans la cavité (C).

4. Module électrique (110) selon l'une des revendications précédentes dans lequel ladite cavité est remplie de gel ou d'une résine présentant une dureté moindre que celle du surmoulage isolant électrique (402).

5. Module électrique (110) selon l'une des revendications précédentes dans lequel le premier élément de liaison électrique (326₁) comprend un ou plusieurs rubans et/ou un ou plusieurs fils et/ou un ou plusieurs fusibles, chacun desdits rubans et/ou chacun desdits fils et/ou chacun desdits fusibles connectant électriquement la face supérieure de la plaque principale (306₁) de la première pièce de connexion électrique (304₁) à la face supérieure de la plaque principale (306₂) de la deuxième pièce pièces de connexion électrique (304₂).

6. Module électrique (110) selon la revendication précédente dans lequel le premier élément de liaison électrique comprend en outre un plot (390₁), une extrémité de chaque ruban en métal (326₁) et/ou de chaque fil et/ou de chaque fusible est soudée sur ledit plot (390₁) par un premier procédé de soudage, par exemple par ultrason, ledit plot (390₁) étant soudé sur la face supérieure de la plaque principale (306₁, 306₂) de la première ou de la deuxième pièce de connexion électrique (304₁, 304₂) par un deuxième procédé de soudage, par exemple par brasage, la soudure obtenue par le deuxième procédé de soudage présentant une tenue en température inférieure à celle obtenue par le premier procédé de soudage, ledit plot (390₁) et l'extrémité de chaque ruban en métal (326₁) et/ou de chaque fil et/ou de chaque fusible soudée sur ledit plot (390₁) sont situés dans la cavité (C).

7. Module électrique (110) selon l'une des revendications précédentes dans lequel ladite première pièce de connexion électrique (304₁) est destinée à être connectée à une borne positive d'une source de tension continue (102) et comprenant en outre :
- une troisième (304₃) et une quatrième (304₄) pièce de connexion électrique présentant une plaque principale s'étendant selon ledit plan principal (PP) ;
- un deuxième élément de liaison électrique (326₂) connectant électriquement ledit premier composant électrique (112₁) à la face supérieure de la plaque principale (306₃) de la troisième pièces de connexion électrique (304₃) ;
- un deuxième composant électrique (114₁) monté sur la face supérieure de la plaque principale (306₃) de la troisième pièce de connexion électrique (304₃) ;
- un troisième élément de liaison électrique (326₃) connectant électriquement ledit deuxième composant électrique (114₁) à la face supérieure de la plaque principale (306₄) de la quatrième pièces de connexion électrique (304₄) ; et
dans lequel le surmoulage isolant électrique (402) recouvre ledit deuxième composant électrique (114₁) et au moins une partie de la face supérieure de la plaque principale (306₃, 306₄) de la troisième (304₃) et de la quatrième (304₄) pièce de connexion électrique.

8. Module électrique (110) selon la revendication précédente dans lequel
- le premier composant électrique (112₁) et le deuxième composant électrique (114₁) sont des transistors appelés respectivement premier et deuxième transistor ;
- le premier transistor (112₁) et le deuxième transistor (114₁) sont connectés électriquement l'un à l'autre par l'intermédiaire de la plaque principale (306₃) de la troisième pièce de connexion électrique (304₃), la plaque principale (306₃) de la troisième pièce de connexion électrique (304₃) étant destinée à être connecté à une phase d'une machine électrique (130),
- le premier transistor (112₁) est en outre connecté électriquement à la plaque principale (306₂) de la deuxième pièces de connexion électrique (304₂),
- la plaque principale (306₁) de la première pièce de connexion électrique (304₁) est destinée à être connectée à une borne positive de ladite source de tension continue (102), et dans lequel
- la plaque principale (306₄) de la quatrième pièces de connexion électrique (304₄) est en outre destiné à être connecté à une borne négative de ladite source de tension continue (102).

9. Module électrique (110) selon l'une des revendications précédentes dans lequel le surmoulage (402) laisse apparent au moins une partie de la face inférieure de la plaque principale (306₂) d'au moins une des pièces de connexion électrique (304₂), cette partie laissée apparente étant conçue pour être plaquée contre un dissipateur thermique (206).

10. Système électrique (100) comprenant un dissipateur thermique et un module électrique (110) selon la revendication précédente, et dans lequel le dissipateur thermique (206) est en contact thermique avec la face inférieure laissée apparente par le surmoulage (402).

11. Convertisseur de tension (104) comprenant un module électrique selon l'une quelconque des revendications 1 à 9 ou bien un système électrique (100) selon la revendication 10.
